# EUROPEAN PATENT APPLICATION

(11) **EP 4 361 309 A1**
(43) Date of publication of application: **01.05.2024**
(21) Application number: 23203050.2
(22) Date of filing: 11.10.2023
(51) Int. Cl.: C23C 16/10, C23C 16/12, C23C 16/458, C23C 10/08, C23C 30/00, F01D 5/28

(54) **DEPOSITION SUPPORT APPARATUS AND METHOD FOR COATING A COMPONENT**

(30) Priority: 27.10.2022 US 202263419779 P; 29.11.2022 US 202218070834
(71) Applicant: General Electric Company, Schenectady, NY 12345 (US)
(72) Inventor: KILYK, Thomas John, Schenectady, 12345 (US); MANTKOWSKI, Thomas Edward, Schenectady, 12345 (US); RAINWATER, Micah Thomas, Schenectady, 12345 (US)
(74) Representative: Openshaw & Co.

(57) **Abstract**

A deposition support apparatus (20) and method (100) for coating a component (10), the deposition support apparatus (20) including a mask container (22) defining an interior (30) and having an opening (34) providing access to the interior (30). A barrier plate (36) with a component aperture (38) wherein the component (10) extends through the component aperture (38) with a first portion (54) of the component (10) located within the interior (30) and a second portion (56) of the component (10) extending above the at least one barrier plate (36).

## Description

### TECHNICAL FIELD

This disclosure generally relates to an apparatus and method for coating a component and more specifically to a deposition support apparatus for holding an engine component during vapor phase deposition coating.

### BACKGROUND

Turbine components for a turbine engine such as airfoils require coatings such as aluminides for environmental protection or as bond coats. Only a portion of the airfoil that is exposed to the hot gases of the environment requires such protection. A remaining portion of the airfoil does not require such protection, wherein coating of the remaining portion is actually undesirable.

Turbine blade assemblies include an airfoil section which extends outward into the hot gases resulting from the combustion of fuel in the combustor portion of the engine. These hot gases provide the energy for operation of the engine and for thrust to propel a turbine powered vehicle. Coating the airfoil section of the turbine blade assembly with protective coatings provides insulation from the extremely high temperatures and environmental protection from the hot gases. The portion of the turbine blade assembly opposite the airfoil section, commonly referred to as a dovetail, is used to attach the airfoil to a disk or rotor part of the engine. The dovetail is not in the flow of hot gases and therefore is not in need of protection.

### BRIEF DESCRIPTION OF THE DRAWINGS

A full and enabling disclosure of the present disclosure, including the best mode thereof, directed to one of ordinary skill in the art, is set forth in the specification, which makes reference to the appended figures, in which:
FIG. 1 is a component in the form of a blade assembly with an airfoil section, platform section, and a dovetail section.
FIG. 2 is a schematic of a deposition support apparatus for the blade assembly of FIG. 1.
FIG. 3 is a top-down perspective view of the deposition support apparatus with the blade assembly illustrated in dashed line.
FIG. 4 is an enlarged view of a schematic view taken along line IV-IV of FIG. 3 according to an aspect of the disclosure herein.
FIG. 5 is a flow chart diagram illustrating a method for coating a component for a turbine engine.

### DETAILED DESCRIPTION

Reference will now be made in detail to present embodiments of the disclosure, one or more examples of which are illustrated in the accompanying drawings. The detailed description uses numerical and letter designations to refer to features in the drawings. Like or similar designations in the drawings and description have been used to refer to like or similar parts of the disclosure.

Aspects of the disclosure generally relate to an apparatus and method for coating an engine component, and more particularly to a deposition support apparatus for holding the engine component during vapor phase deposition coating of an airfoil section of the engine component. For purposes of illustration, the present disclosure will be described with respect to coating of the airfoil. It will be understood, however, that aspects of the disclosure described herein are not so limited and may have general applicability within other coating methods and support apparatuses. The support apparatus and coating method can be utilized on any suitable component.

In the non-limiting example of the airfoil, the dovetail connects the turbine blade assembly to a rotor in a turbine engine to define a rotor/dovetail interface. During operation, the rotor/dovetail interface is loaded from high-speed rotation. Coating on the dovetail can increase friction at the rotor/dovetail interface. Coating on the dovetail can therefore exacerbate a fatigue-related phenomenon referred to as fretting. In order to diminish fretting and maximize the life of the blade assembly, it is beneficial to properly coat the airfoil section while keeping the dovetail portion free of any coating. In other words, the turbine blade assembly is split into a vapor coated portion and an uncoated portion. Proper coating placement on the turbine blade assembly is necessary to maximize the life of the blade assembly. Normally this is a time intensive process utilizing masking materials on the dovetail while coating the airfoil section.

The current process is time consuming and requires skilled technicians. Small components can be difficult to mask because a transition zone, an area between the vapor coated portion and the uncoated portion is very small. Turbine blade assemblies with more geometrically complicated under platforms are also difficult to mask. A physical barrier to ensure the proper transition length and protection of the dovetail section is contemplated here.

The word "exemplary" may be used herein to mean "serving as an example, instance, or illustration." Any implementation described herein as "exemplary" is not necessarily to be construed as preferred or advantageous over other implementations. Additionally, unless specifically identified otherwise, all embodiments described herein should be considered exemplary.

As may be used herein, the terms "first," "second," and "third" can be used interchangeably to distinguish one component from another and are not intended to signify location or importance of the individual components.

The singular forms "a", "an", and "the" include plural references unless the context clearly dictates otherwise.

All directional references (e.g., radial, axial, proximal, distal, upper, lower, upward, downward, left, right, lateral, front, back, top, bottom, above, below, vertical, horizontal, clockwise, counterclockwise, upstream, downstream, forward, aft, etc.) are only used for identification purposes to aid the reader's understanding of the present disclosure, and do not create limitations, particularly as to the position, orientation, or use of aspects of the disclosure described herein. Connection references (e.g., attached, coupled, connected, and joined) are to be construed broadly and can include intermediate structural elements between a collection of elements and relative movement between elements unless otherwise indicated. As such, connection references do not necessarily infer that two elements are directly connected and in fixed relation to one another. The exemplary drawings are for purposes of illustration only and the dimensions, positions, order and relative sizes reflected in the drawings attached hereto can vary.

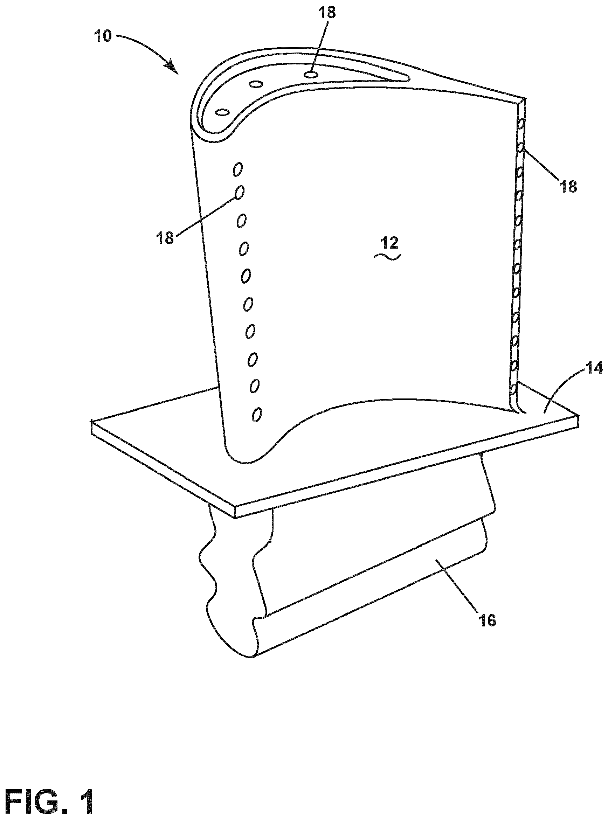

Referring to FIG. 1 a component, by way of non-limiting example a blade assembly 10 having an airfoil section 12, a platform section 14, and a dovetail section 16 is illustrated.% Cooling holes 18 can be located anywhere on the airfoil section 12. The airfoil section 12 requires coating while the dovetail section 16 needs to remain uncoated. When in a turbine engine, during operation, the airfoil section is generally positioned within the hot gasses that are produced by the combustor of the gas turbine engine. Therefore, the airfoil section 12 needs to be coated with materials that protect it from the harsh environment of the hot gases and coated while still ensuring the cooling holes 18 remain open. The blade assembly 10 is an exemplary blade assembly, and it should be understood that the disclosure herein can be applied to any engine component or non-engine component requiring partial coating.

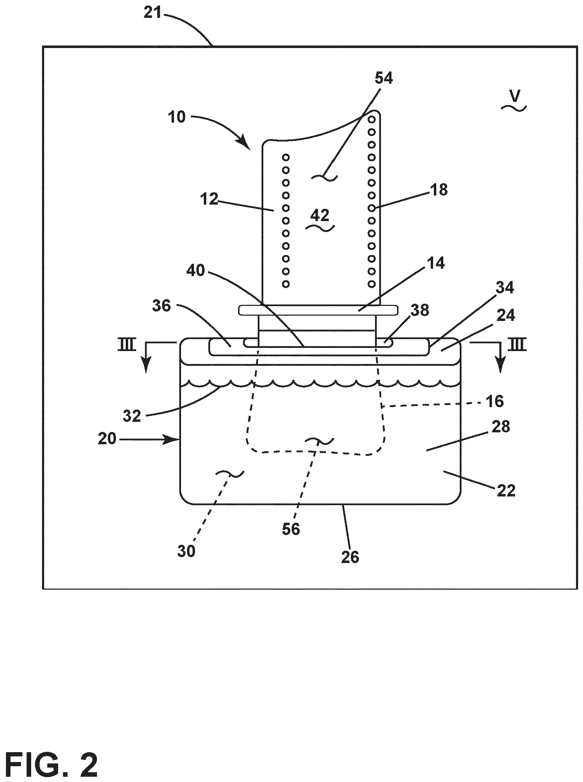

FIG. 2 is a schematic of a deposition support apparatus 20 for the blade assembly 10 of FIG. 1. The deposition support apparatus 20 is configured to provide support to the blade assembly 10 during a coating process, by way of non-limiting example a vapor phase deposition coating process. It is contemplated that the coating of the airfoil section 12 may be within a vacuum (denoted "V" and defined by the solid line barrier) or coating chamber 21. The deposition support apparatus 20 can include a mask container 22 having a top 24, a bottom 26, and sidewalls 28 defining an interior 30 sized to envelop the dovetail section 16 of the blade assembly 10. The interior 30 can hold a masking material 32, by way of non-limiting example a slurry masking material. Any masking material capable of protecting the dovetail section 16 during a coating process of the airfoil section 12 is contemplated, for example tape, slurry, putties, or any combination thereof.

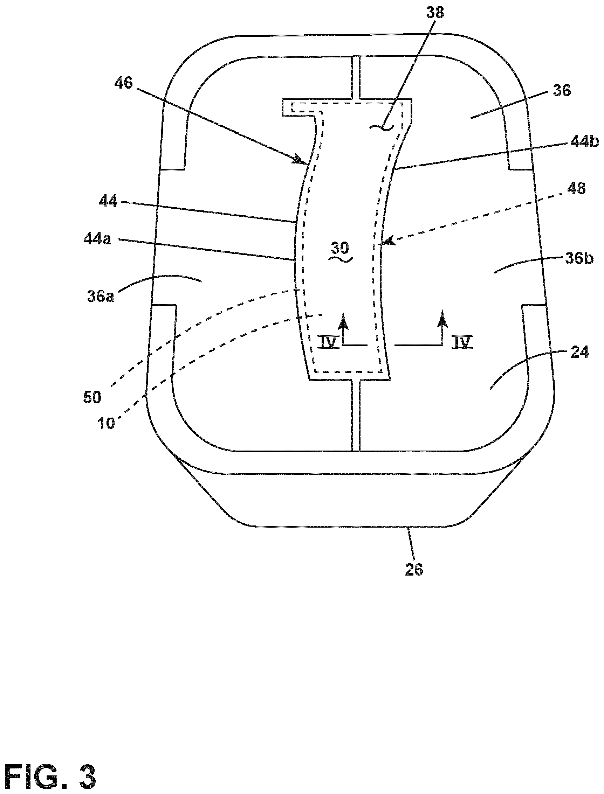

An opening 34 can be provided on the top 24 of the mask container 22 providing access to the interior 30. At least one barrier plate 36 can be sized to fit into the opening 34. The at least one barrier plate 36 is placed in the opening 34 prior to the coating process to further protect and block the dovetail section 16 from any coating contacting the dovetail section 16 during the coating process. The at least one barrier plate 36 can include one or more pieces that define a barrier line 40 dividing an exterior surface 42 of the blade assembly 10 into a first portion to be coated, referred to herein as a vapor coated portion 54 and a second portion to be masked from coating, referred to herein as an uncoated portion 56. It is contemplated that a component aperture 38 can be defined by the at least one barrier plate 36. The component aperture 38 is conforming to a cross-sectional shape 48 (FIG. 3) of the blade assembly 10 such that the blade assembly 10 extends through the component aperture 38 with the dovetail section 16 located within the interior 30 and the airfoil section 12 and platform section 14 both located above the barrier line 40. The component aperture 38 may be negligibly larger than the cross-section of the component being held. Further in the instance where multiple pieces form the at least one barrier plate 36 it is contemplated that the multiple pieces may define the component aperture 38.

FIG. 3 is a top-down perspective view of the deposition support apparatus 20 with the blade assembly 10 illustrated in dashed line. The at least one barrier plate 36 can be a formed from a thin metal or non-metal, or a combination of metal and non-metal. The at least one barrier plate 36 can have a thickness of between 0.05 mm and 3 mm.

The at least one barrier plate 36 can be one solid piece, or multiple sections 36a, 36b, as illustrated, together defining the at least one barrier plate 36. A profile 44 of the component aperture 38 can define a complementary shape 46 to a cross-sectional shape 48 of the blade assembly 10 taken along line III-III of FIG. 2 at the barrier line 40. The profile 44 can be precisely cut or precision cut to be conforming to the cross-sectional shape 48 of the blade assembly 10. The profile 44 of the at least one barrier plate 36 is spaced from the blade assembly 10 to define an offset gap 50. The at least one barrier plate 36 can conform tightly to the blade assembly 10 such that the offset gap 50 is negligible. In this manner, the blade assembly 10 (FIG. 2) can be turned upside down such that the at least one barrier plate 36 holds the masking material 32 in place.

A first section 36a can include a first cut-out 44a and a second section 36b can include a second cut-out 44b. Together the first cut-out 44a and the second cut-out 44b can define the profile 44 of the component aperture 38. That the at least one barrier plate 36 conforms to the component being coated to enable tighter transitions between coated and uncoated areas and more robustness and repeatability for the masking and coating processes. While cutting has been discussed it will be understood that the at least one barrier plate 36 can be formed in a conforming matter in any suitable way.

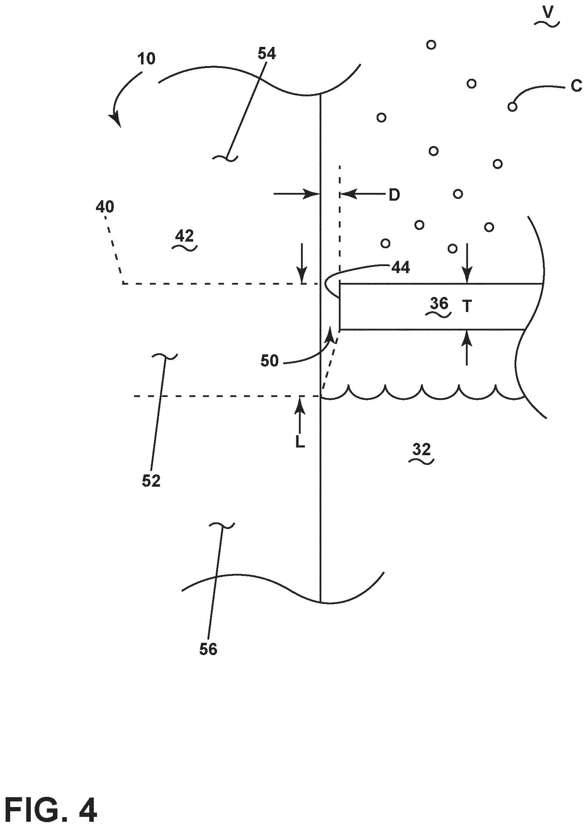

FIG. 4 is an enlarged view of a schematic cross-section taken along line IV-IV of FIG. 3. The profile 44 of the at least one barrier plate 36 is spaced from the blade assembly 10 a predetermined distance (denoted "D") to define an offset gap 50 of greater than or equal to 0 and less than or equal to 0.2 inches (.508cm). It will be understood that the at least one barrier plate 36 may conform to the component such that little to no offset gap is present. The little to no presence of an offset gap 50 enables a controlled and minimum transition of coating (denoted "C") on the blade assembly 10 from the vapor coated portion 54 to the uncoated portion 56 of the blade assembly 10. More specifically, a transition zone 52 is located between the vapor coated portion 54 to the uncoated portion 56 of the blade assembly 10. The use of the at least one barrier plate 36 limits the size of such transition zone 52. That the at least one barrier plate 36 conforms to the component being coated which results in the predetermined distance D of the offset gap 50. At least one feature of the at least one barrier plate 36, be it the amount of conforming, the offset gap 50, or a combination of both, determines a transition length (denoted "L") for a transition zone 52. Again, while a gap having a nominal width is shown it will be understood that the conformity may be so precise that no gap is present.

Transition zones with a transition length L greater than or equal to 0 and less than or equal to 0.10 inches (.254 cm) (0 ≤ L ≤ 0.10 in) have been produced using this process. More precisely, where the transition length is less than 0.10 inches (.254 cm) measured from the barrier line 40 to the uncoated portion 56 and greater than or equal to 0 and less than or equal to 0.06 inches (0.1524cm) (0 ≤ L ≤ 0.06 in) has been obtained using this technique. Generally, the smallest transition length L which can be economically produced is desired. Along this transition length L, the transition zone 52 has a continuously decreasing amount of coating C from the vapor coated portion 54 to the uncoated portion 56. In other words, the vapor coated portion 54 defines a coated area while the uncoated portion 56 defines a uncoated area and the transition zone 52 defines an area of controlled transitioning. By way of non-limiting example, the vapor coated portion can have 100% coating coverage whereas the uncoated portion 56 would have 0% coating coverage. In such a non-limiting example the transition zone 52 would have a transition from 100% coating to 0% coating. It will be understood that the vapor coated portion 54 need not be 100% coated and that such percentage is merely exemplary. The masking material 32 is shown below the at least one barrier plate 36 for clarity. In practice, the masking material can fill the interior 30 up to the at least one barrier plate 36 in order to minimize the transition length L when small transition zones are desired. Further still, it will be understood that the masking material 32 may be in contact with the component such that the at least one barrier plate 36 directly contacts the masking material 32 or such that at least a portion of the offset gap 50 is filled with the masking material 32. In other words, in one non-limiting example, where the blade assembly 10 is turned for the coating process, the masking material 32 would be in contact with the at least one barrier plate 36 such that the masking material 32 is held by the at least one barrier plate 36.

A thickness (denoted "T") of the at least one barrier plate 36 can be selected to enhance the masking performance and improve the masking process efficiency. Thin barriers (0.05 mm - 1.5 mm) can be used to minimize the resulting transition length L. Further thin barriers can render the at least one barrier plate 36 less expensive and single use. Thicker barriers (1.5 mm - 3 mm) could be used for mechanical strength and reusability. Similarly, the material used for the at least one barrier plate 36 can be selected based upon cost, durability, and reactivity in the coating environment. Single use barriers for non-demanding, or greater than 0.06 inches (.1524 cm) transition zone lengths could be fabricated from any material which can tolerate the coating process for at least one run.

Materials with a low thermal expansion coefficient, less than or equal to 5×10⁻⁶/K at 25°C, such as molybdenum, tungsten, or graphite, are suitable for forming the at least one barrier plate 36 when smaller transition zones are required, as those low expansion materials will provide for smaller offset gaps 50 at high coating temperatures. By way of further non-limiting example, the at least one barrier plate 36 can be formed from materials that are inert to the process environment and are therefore long lasting in the coating environment. The pieces may be used, by way of further non-limiting example, in an Aluminide environment. The pieces may be used, by way of further non-limiting example, or made from a material which would coat in the process and function as a getter to aid in masking during the coating process. For example, the pieces may act as a getter to aid in masking for chromide coating operations or other coating operations.

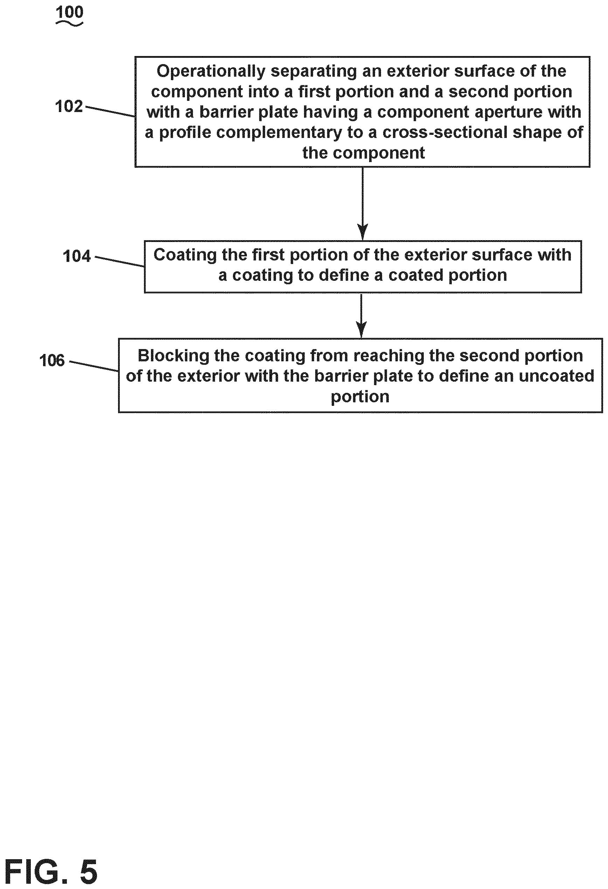

FIG. 5 is a flow chart illustrating a method 100 for coating a component including by way of non-limiting example a component for a turbine engine. The method 100 includes, at 102, operationally separating an exterior surface 42 of the component, the blade assembly 10 herein, into a first portion vapor coated portion 54, and a second portion 56 with the at least one barrier plate 36. The at least one barrier plate 36 including the component aperture 38 having the profile 44 complementary to the cross-sectional shape 48 as described herein. At 104 coating the first portion of the exterior surface 42 with the coating C to define the vapor coated portion 54. At 106 blocking the coating from reaching the second portion of the exterior 42 with the at least one barrier plate 36 to define the uncoated portion 56. It will be understood that the coating of 104 and blocking of 106 occur at the same time.

Further, any transition zone 52 may be formed by receiving a portion of the coating C through any present offset gap 50 to define a transition zone 52 of the exterior surface 42. Thus, the method 100 can further include receiving the portion of coating through the offset gap having dimensions described herein and coating the transition zone 52 with a changing coating coverage amount along the transition length L described herein. The method can further include forming the at least one barrier plate with a material having a thermal expansion coefficient less than or equal to 5×10⁻⁶/K at 25°C. Furthermore, operationally separating the exterior surface 42 can include operationally separating the exterior surface 42 with the first section 36a and the second section 36b of the at least one barrier plate 36. Additionally, the method 100 can include cutting out the first cut-out 44a in the first section 36a and cutting out the second cut-out 44b in the section 36b to define the profile 44.

Benefits associated with the deposition support apparatus along with placement of the at least one barrier plate include enabling repeatability in meeting small transition lengths on small blades that require aluminide or chromide coatings. The profile precisely cut to conform to any component shape enables the component to be masked with the masking material completely filling the interior to produce a minimal transition length L. Such complete filling could be accomplished by filling the interior with the masking material while the blade 10 is oriented with a tip of the blade facing down. Aspects of the present disclosure use thin, conforming pieces as part of the masking process to act as a diffusion barrier and means to hold the masking media in place. Aspects of the present disclosure allow for tighter transitions and more robustness and repeatability in the masking process.

The method of coating described herein enables tighter coating transitions than traditionally produced. The deposition support apparatus contributes to a more robust masking process and a reduction in touch time during the masking process. A transition from full coating to no coating in .06 inches is over a 60% decrease in known transition lengths (0.02 inches and greater). The method described herein enables meeting any future requirements regarding smaller and smaller transition zones. The deposition support apparatus increases both precision and accuracy for the coating of components.

It should be understood that any combination of the geometry related to the deposition support apparatus discussed herein is contemplated. The varying aspects of the disclosure discussed herein are for illustrative purposes and not meant to be limiting. It should be appreciated that application of the disclosed design can be for any applicable components, including any component in need of coating and masking. It will be understood that the deposition support apparatus is shown in a specific configuration for the exemplary component but may be configured in any suitable form to act as a diffusion barrier during the coating process. More specifically, the deposition support apparatus can include any suitable barriers or pieces to prevent or otherwise limit coating vapors from getting to the masking material or surface of the component.

This written description uses examples to describe aspects of the disclosure described herein, including the best mode, and also to enable any person skilled in the art to practice aspects of the disclosure, including making and using any devices or systems and performing any incorporated methods. The patentable scope of aspects of the disclosure is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

Further aspects are provided by the subject matter of the following clauses:
A deposition support apparatus comprising a mask container defining an interior and having an opening providing access to the interior; and at least one barrier plate sized to fit into the opening and defining a component aperture with a profile conforming to a shape of a component, the at least one barrier plate abutting or located a predetermined distance from the component to define an offset gap; wherein when the component is located within the component aperture a first portion of the component is located below the at least one barrier plate and within the interior and a second portion of the component extends above the at least one barrier plate.

The deposition support apparatus of any preceding clause wherein the profile defining the component aperture is complementary to a cross-sectional shape of the component taken along a barrier line defined by the at least one barrier plate.

The deposition support apparatus of any preceding clause wherein the offset gap is less than 0.508 cm.

The deposition support apparatus of any preceding clause wherein at least one feature of the at least one barrier plate determines a transition length of a transition zone located between the first portion and the second portion of the component.

The deposition support apparatus of any preceding clause wherein the transition length is less than 0.254 cm.

The deposition support apparatus of any preceding clause wherein the transition length is less than or equal to 0.1524 cm.

The deposition support apparatus of any preceding clause wherein the at least one barrier plate is formed from a material with a thermal expansion coefficient less than or equal to 5×10-6/K at 25°C.

The deposition support apparatus of any preceding clause wherein the at least one barrier plate is formed from molybdenum.

The deposition support apparatus of any preceding clause wherein the at least one barrier plate comprises multiple sections and wherein the multiple sections define the component aperture.

The deposition support apparatus of any preceding clause wherein a masking material is held within the mask container.

The deposition support apparatus of any preceding clause wherein the masking material is held by the at least one barrier plate.

The deposition support apparatus of any preceding clause wherein the masking material is located within the gap.

A component comprising an exterior surface having a vapor coated portion on a first portion of the exterior surface, an uncoated portion on a second portion of the exterior surface the second portion different from the first portion, and a transition zone extending a transition length between the first portion and the second portion, wherein the transition zone is defined by a changing coating coverage amount along the transition length, and the transition length is less than or equal to 0.254 cm.

The component of any preceding clause wherein the transition length is greater than or equal to 0 and less than or equal to 0.1524 cm (0 < L < 0.1524).

The component of any preceding clause wherein the component is a blade assembly with a dovetail section, a platform section, and an airfoil section, wherein the dovetail section defines the uncoated portion and the airfoil section defines the vapor coated portion.

The component of any preceding clause wherein the platform section further defines the vapor coated portion and the transition zone is located between the platform section and the dovetail section.

The component of any preceding clause wherein the vapor coated portion comprises 100% coating coverage.

The component of any preceding clause wherein the uncoated portion comprises 0% coating coverage.

A method for coating a component, the method comprising separating an exterior surface of the component into a first portion and a second portion with at least one barrier plate having a profile complimentary to the exterior surface of the component; coating the first portion of the exterior surface with a coating to define a vapor coated portion; and blocking the coating from reaching the second portion of the exterior surface with the at least one barrier plate to define an uncoated portion and wherein any transition zone between the first portion of the exterior surface and the second portion of the exterior surface is less than or equal to 0.254cm.

The method of any preceding clause further comprising masking the uncoated portion with a masking material and holding the masking material with the at least one barrier plate.

The method of any preceding clause wherein the at least one barrier plate is spaced a predetermined distance from the exterior surface to define an offset gap and further comprising receiving a portion of the coating through the offset gap to define the transition zone.

The method of any preceding clause, wherein the offset gap has a size less than 0.508 cm.

The method of any preceding clause, further comprising coating the transition zone with a changing coating coverage amount along a transition length greater than or equal to 0 and less than or equal to 0.254 cm (0 < L < 0.254).

The method of any preceding clause, further comprising forming the at least one barrier plate with a material with a thermal expansion coefficient less than or equal to 5×10-6/K at 25°C.

The method of any preceding clause, further comprising cutting out a first cut-out in the first section and cutting out a second cut-out in the second section to define the profile.

A deposition support apparatus for a component, the deposition support apparatus comprising a mask container defining an interior and having an opening providing access to the interior; and a barrier plate sized to fit into the opening and defining a component aperture with a profile for receiving a shape of the component, the profile spaced from the component a predetermined distance to define an offset gap; wherein the component extends through the component aperture with a first portion of the component located within the interior and a second portion of the component extending above the barrier plate.

The deposition support apparatus of any preceding clause wherein the profile defining the component aperture is complementary to a cross-sectional shape of the component taken along a barrier line defined by the barrier plate.

The deposition support apparatus of any preceding clause wherein the offset gap is between 0 and 0.020 inches.

The deposition support apparatus of any preceding clause wherein the offset gap determines a transition length of a transition zone located between the first portion and the second portion of the component and extending from the barrier line to the second portion.

The deposition support apparatus of any preceding clause wherein the transition length is less than 0.1 inches.

The deposition support apparatus of any preceding clause wherein the transition length is less than or equal to 0.06 inches.

The deposition support apparatus of any preceding clause wherein the barrier plate is formed from a material with a thermal expansion coefficient less than or equal to 5x10-6/K at 25°C.

The deposition support apparatus of any preceding clause wherein the barrier plate is formed from molybdenum.

The deposition support apparatus of any preceding clause wherein the barrier plate comprises multiple sections.

The deposition support apparatus of any preceding clause wherein each section of the multiple sections has a corresponding cut-out, which together define the component aperture.

A component for a turbine engine, the component comprising an exterior surface having a coated portion defined by a 100% coating coverage amount on the exterior surface, an uncoated portion defined by a 0% coating coverage amount on the exterior surface, and a transition zone extending a transition length between the coated portion and the uncoated portion, wherein the transition zone is defined by a changing coating coverage amount along the transition length, and the transition length is less than or equal to 0.1 inches.

The component of any preceding clause wherein the transition length is greater than or equal to 0 and less than or equal to 0.06 inches (0 < L < 0.06).

The component of any preceding clause wherein the component is a blade assembly with a dovetail section, a platform section, and an airfoil section, wherein the dovetail section defines the uncoated portion and the airfoil section defines the coated portion.

The component of any preceding clause wherein the platform section further defines the coated portion and the transition zone is located between the platform section and the dovetail section.

A method for coating a component for a turbine engine, the method comprising: operationally separating an exterior surface of the component into a first portion and a second portion with a barrier plate having a profile defining a component aperture larger than a cross-sectional shape of the component; spacing the component from the profile a predetermined distance defining an offset gap; coating the first portion of the exterior surface with a coating to define a coated portion; receiving a portion of the coating through the offset gap to define a transition zone of the exterior surface; blocking the coating from reaching the second portion of the exterior surface with the barrier plate to define an uncoated portion.

The method of any preceding clause wherein receiving the portion of the coating comprises receiving the portion of the coating through the offset gap having a size of between 0 and 0.020 inches.

The method of any preceding clause further comprising coating the transition zone with a changing coating coverage amount along a transition length greater than or equal to 0 and less than or equal to 0.10 inches (0 < L < 0.10).

The method of any preceding clause further comprising forming the barrier plate with a material with a thermal expansion coefficient less than or equal to 5x10-6/K at 25°C.

The method of any preceding clause wherein operationally separating the exterior surface further comprises separating the exterior surface with a first section of the barrier plate and a second section of the barrier plate.

The method of any preceding clause further comprising cutting out a first cut-out in the first section and cutting out a second cut-out in the second section to define the profile.

## Claims

1. A deposition support apparatus (20) comprising:
a mask container (22) defining an interior (30) and having an opening (34) providing access to the interior (30); and
a barrier plate (36) sized to fit into the opening (34) and defining a component aperture (38) with a profile (44) conforming to a shape (48) of a component (10), the at least one barrier plate (36) abutting or located at a predetermined distance (D) from the component (10) to define an offset gap (50);
wherein when the component (10) is located within the component aperture (38) a first portion (54) of the component (10) is located below the at least one barrier plate (36) and within the interior (30) and a second portion (56) of the component (10) extends above the at least one barrier plate (36).

2. The deposition support apparatus (20) of claim 1 wherein the profile (44) defining the component aperture (38) is complementary to a cross-sectional shape (48) of the component (10) taken along a barrier line (40) defined by the at least one barrier plate (36).

3. The deposition support apparatus (20) of any of claims 1-2 wherein the offset gap (50) is less than 0.508 cm.

4. The deposition support apparatus (20) of any of claims 1-3 wherein at least one feature of the at least one barrier plate (36) determines a transition length (L) of a transition zone (52) located between the first portion (54) and the second portion (56) of the component (10).

5. The deposition support apparatus (20) of any of claims 1-4 wherein the transition length (L) is less than 0.254 cm.

6. The deposition support apparatus (20) of claim 5 wherein the transition length (L) is less than or equal to 0.1524 cm.

7. The deposition support apparatus (20) of any of claims 1-6 wherein the at least one barrier plate (36) is formed from a material with a thermal expansion coefficient less than or equal to 5×10⁻⁶/K at 25°C.

8. The deposition support apparatus (20) of any of claims 1-7 wherein the at least one barrier plate (36) is formed from molybdenum.

9. The deposition support apparatus (20) of any of claims 1-8 wherein the at least one barrier plate (36) comprises multiple sections (36a, 36b) and wherein the multiple sections (36a, 36b) define the component aperture (38).

10. The deposition support apparatus (20) of any of claims 1-9 wherein a masking material (32) is held within the mask container (22).

11. The deposition support apparatus of claim 10 wherein the masking material (32) is held by the at least one barrier plate (36).

12. The deposition support apparatus of claim 11 wherein the masking material (32) is located within the offset gap (50).

13. The deposition support apparatus (20) of any of claims 1-12 wherein the component (10) comprises an exterior surface (42) having a coated portion (54) defined by a 100% coating coverage amount on the exterior surface (42), an uncoated portion (56) defined by a 0% coating coverage amount on the exterior surface (42), and a transition zone (52) extending a transition length (L) between the coated portion (54) and the uncoated portion (56), wherein the transition zone (52) is defined by a changing coating coverage amount along the transition length (L), and the transition length (L) is less than or equal to 0.1 inches.

14. The deposition support apparatus (20) of claim 13 wherein the transition length is greater than or equal to 0 and less than or equal to 0.1524 cm (0 ≤ L ≤ 0.1524).

15. The deposition support apparatus (20) of any of claims 13-14 wherein the component (10) is a blade assembly (10) with a dovetail section (16), a platform section (14), and an airfoil section (12), wherein the dovetail section (16) defines the uncoated portion (56) and the airfoil section (12) defines the coated portion (54).
